# EUROPEAN PATENT APPLICATION

(11) **EP 4 769 488 A1**
(43) Date of publication of application: **01.07.2026**
(21) Application number: 24888887.7
(22) Date of filing: 29.07.2024
(51) Int. Cl.: H01L 23/00, H01L 21/683, H10H 20/857

(54) **ALIGNMENT STRUCTURE OF LIGHT-EMITTING ELEMENT, DISPLAY DEVICE, AND METHOD FOR MANUFACTURING SAME**

(30) Priority: 07.11.2023 KR 20230152918
(71) Applicant: Samsung Electronics Co., Ltd., Suwon-si, Gyeonggi-do 16677 (KR)
(72) Inventor: LEE, Keewon, Suwon-si Gyeonggi-do 16677 (KR); KANG, Kihyung, Suwon-si Gyeonggi-do 16677 (KR); KIM, Myunghee, Suwon-si Gyeonggi-do 16677 (KR); KIM, Changjae, Suwon-si Gyeonggi-do 16677 (KR)
(74) Representative: Appleyard Lees IP LLP
(86) International application number: PCT/KR2024/011037
(87) International publication number: WO 2025/100691

(57) **Abstract**

A method of manufacturing a display device including: providing a plurality of light emitting elements to a base substrate through a fluid layer, the base substrate including an alignment area and a non-alignment area; aligning a first light emitting element provided to the alignment area of the base substrate to at least one electrode using an electric field; and moving a second light emitting element provided to the non-alignment area of the base substrate to the alignment area by applying a flow to the fluid layer.

## Description

### [TECHNICAL FIELD]

This disclosure relates to an alignment structure for efficiently aligning light emitting elements, a display device, and a method for manufacturing the same.

### [BACKGROUND ART]

Display devices are devices that process image signals and image data input from the outside or stored internally through various processes and display them as images on a display panel or screen and may be implemented as various ones, such as TVs, monitors, or portable media players.

Recently, various types of display devices, such as organic light emitting displays (OLEDs) and liquid crystal displays (LCDs), are being used according to the development of multimedia. A display device is a device that displays images and may include a display panel, such as an organic light emitting display panel or a liquid crystal display panel. The display panel may include light emitting elements. For example, the display panel may include a light emitting diode (LED) such as an organic light emitting diode (OLED) using an organic material as the fluorescent material, and an inorganic LED using an inorganic material as the fluorescent material.

The inorganic light emitting diode using an inorganic semiconductor as the fluorescent material may have durability even in a high temperature environment, and may have an advantage in that blue light is more efficient than the organic light emitting diode. Further, a transfer method using electrophoresis or dielectrophoresis has been developed in the manufacturing process that has been known as a limitation in conventional inorganic light emitting diode elements. Accordingly, research on inorganic light emitting diodes having superior durability and efficiency compared to organic light emitting diodes continues.

### [DISCLOSURE OF INVENTION]

### [TECHNICAL PROBLEM]

Provided is an alignment structure of a light emitting element that may increase the transfer yield of the light emitting element by moving a dummy light emitting element in a non-alignment area to the alignment area using a flow supplied to a fluid layer, and a method for manufacturing a display device using the alignment structure.

### [SOLUTION TO PROBLEM]

According to an aspect of the disclosure, a method of manufacturing a display device may include: providing a plurality of light emitting elements to a base substrate through a fluid layer, the base substrate including an alignment area and a non-alignment area; aligning a first light emitting element provided to the alignment area of the base substrate to at least one electrode using an electric field; and moving a second light emitting element provided to the non-alignment area of the base substrate to the alignment area by applying a flow to the fluid layer.

The providing of the plurality of light emitting elements to the base substrate through the fluid layer may include: lowering at least one of the plurality of light emitting elements in a vertical direction by gravity in a gravitational influence zone of the fluid layer; and rotating the at least one of the plurality of light emitting elements by at least one of electrophoresis and dielectrophoresis in an electric field influence zone of the fluid layer.

The moving of the second light emitting element provided to the non-alignment area of the base substrate to the alignment area by applying the flow to the fluid layer may include: aligning the second light emitting element to the at least one electrode of the alignment area by moving the second light emitting element to at least one of the gravitational influence zone and the electric field influence zone of the alignment area using a flow supply apparatus.

The using the flow supply apparatus may include: generating the flow using a flow medium with a flow generator; injecting the flow from a flow supply line into the fluid layer with a flow injector; and controlling the flow of the flow supply line based on a measurement of the flow with a flow controller.

The generating the flow using the flow medium may include: outputting the flow medium including at least one of liquid and gas to the flow supply line at a predetermined speed.

The injecting the flow from the flow supply line into the fluid layer may include: injecting the flow from a plurality of flow injectors provided at intervals in the non-alignment area of the base substrate.

The controlling the flow of the flow supply line based on the measurement of the flow may include: reducing the flow based on the flow of the flow supply line being faster than a predetermined reference flow; and increasing the flow based on the flow of the flow supply line being slower than the predetermined reference flow.

The injecting the flow from the flow supply line into the fluid layer may include: injecting the flow medium in one direction through an injection port, where the moving the second light emitting element provided to the non-alignment area of the base substrate to the alignment area by applying the flow to the fluid layer includes: moving the second light emitting element to at least one alignment area adjacent to the non-alignment area by applying the flow in a direction within the fluid layer through the injection port.

The injecting the flow from the flow supply line into the fluid layer may include: injecting the flow through two injection ports injecting the flow medium in a first direction and a second direction different from the first direction, where the moving the second light emitting element provided to the non-alignment area of the base substrate to the alignment area by applying the flow to the fluid layer includes: moving the second light emitting element to at least one alignment area adjacent to the non-alignment area by applying the flow in the first direction and the second direction through the two injection ports.

The injecting the flow from the flow supply line into the fluid layer may include: generating a vortex in at least one of a clockwise direction and a counterclockwise direction in the fluid layer by injecting the flow medium, where the moving the second light emitting element provided to the non-alignment area of the base substrate to the alignment area by applying the flow to the fluid layer includes: moving the second light emitting element to at least one alignment area adjacent to the non-alignment area based on the vortex.

According to an aspect of the disclosure, a display device may include: at least one electrode; and a plurality of light emitting elements aligned with the at least one electrode, where, in a process of aligning the plurality of light emitting elements to the at least one electrode, the plurality of light emitting elements are supplied to a fluid layer, and provided to a base substrate including an alignment area and a non-alignment area, where a first light emitting element provided to the alignment area is aligned with the at least one electrode using an electric field, and where a second light emitting element provided to the non-alignment area moves to the alignment area based on a flow applied to the fluid layer.

In the process of aligning the plurality of light emitting elements to the at least one electrode: at least one of the plurality of light emitting elements may be lowered in a vertical direction by gravity in a gravitational influence zone of the fluid layer, and is rotated by at least one of electrophoresis and dielectrophoresis in an electric field influence zone of the fluid layer.

The second light emitting element provided to the non-alignment area of the plurality of light emitting element may be aligned with the at least one electrode of the alignment area by being moved to at least one of the gravitational influence zone and the electric field influence zone of the alignment area by a flow supply apparatus.

According to an aspect of the disclosure, an alignment structure of a light emitting element may include: a base substrate including an alignment area and a non-alignment area; at least one electrode provided on the base; and a flow supply apparatus provided on the base substrate, where based on a first light emitting element, among a plurality of light emitting elements, being provided through a fluid layer to at least one electrode of the alignment area, an electric field is configured such that the first light emitting element aligns with the at least one electrode, and where the flow supply apparatus is configured to move a second light emitting element, among the plurality of light emitting elements, in the non-alignment area to the alignment area by applying a flow to the fluid layer.

Based one of the plurality of the light emitting elements being lowered in a vertical direction by gravity in a gravitational influence zone of the fluid layer, the electric field may be configured such that the one of the plurality of light emitting elements: rotates by at least one of electrophoresis and dielectrophoresis in an electric field influence zone of the fluid layer, and aligns with the at least one electrode.

The flow supply apparatus may be configured to align the second light emitting element in the non-alignment area to the at least one electrode of the alignment area by moving the second light emitting element to at least one of the gravitational influence zone and the electric field influence zone of the alignment area.

The flow supply apparatus may include: a flow generator configured to generate the flow using a flow medium; a flow injector configured to inject the flow transferred to a flow supply line into the fluid layer; and a flow controller configured to measure the flow of the flow supply line and control the flow.

The flow generator may be configured to generate the flow by outputting the flow medium including at least one of liquid and gas to the flow supply line at a predetermined speed.

The flow injector may be provided at intervals in the non-alignment area of the base substrate.

The flow controller is configured to: reduce the flow based on the flow of the flow supply line being faster than a predetermined reference flow; and increase the flow based on the flow of the flow supply line being slower than the predetermined reference flow.

### [ADVANTAGEOUS EFFECTS]

According to various embodiments of the disclosure, an alignment structure of a light emitting element, a display device, and a method for manufacturing the same may move a dummy light emitting element in a non-alignment area to an alignment area by supplying a flow to a fluid layer.

Accordingly, the alignment structure of the light emitting element, the display device, and the method for manufacturing the same according to the disclosure may increase the transfer yield of the light emitting element by increasing the probability that the light emitting element of the fluid layer is aligned with the electrode.

Effects achievable in example embodiments of the disclosure are not limited to the above-mentioned effects, but other effects not mentioned may be apparently derived and understood by one of ordinary skill in the art to which example embodiments of the disclosure pertain, from the following description. In other words, unintended effects in practicing embodiments of the disclosure may also be derived by one of ordinary skill in the art from example embodiments of the disclosure.

### [BRIEF DESCRIPTION OF DRAWINGS]

The above and other aspects, features, and advantages of certain embodiments of the disclosure will be more apparent from the following description taken in conjunction with the accompanying drawings, in which:
FIG. 1 is a plan view illustrating a display device according to an embodiment;
FIG. 2 illustrates a light emitting element according to an embodiment;
FIG. 3 is a cross-sectional view illustrating a display device according to an embodiment;
FIG. 4 illustrates a transfer process of a light emitting element according to an embodiment;
FIG. 5 illustrates a force received by a light emitting element during an alignment process according to an embodiment;
FIG. 6 is a cross-sectional view illustrating an alignment structure of a light emitting element according to an embodiment;
FIG. 7 is a perspective view illustrating an alignment structure of a light emitting element according to an embodiment;
FIG. 8 illustrates a light emitting element moving from a non-alignment area to an alignment area according to an embodiment;
FIG. 9 illustrates a flow supply apparatus for supplying a flow in one direction to a fluid layer according to an embodiment;
FIG. 10 illustrates a flow supply apparatus for supplying flows in both directions to a fluid layer according to an embodiment;
FIG. 11 is a view illustrating a flow supply apparatus for forming a vortex by supplying a flow to a fluid layer according to an embodiment; and
FIG. 12 illustrates a method for manufacturing a display device using an alignment structure according to an embodiment.

### [MODE FOR THE INVENTION]

Embodiments of the disclosure are now described with reference to the accompanying drawings in such a detailed manner as to be easily practiced by one of ordinary skill in the art. However, the disclosure may be implemented in other various forms and is not limited to the embodiments set forth herein. The same or similar reference denotations may be used to refer to the same or similar elements throughout the specification and the drawings. Further, for clarity and brevity, no description is made of well-known functions and configurations in the drawings and relevant descriptions.

As used herein, the terms 'first' and 'second' are used to simply distinguish between the components, and do not necessarily mean the corresponding components. In other words, the components denoted by the terms 'first' and 'second' are not necessarily limited to a specific structure or position but, in some cases, may be denoted by other numbers.

Accordingly, the numbers assigned to the respective components may be described in the following description taken in conjunction with the drawings, and the first component mentioned below may be a second component within the technical spirit of the disclosure.

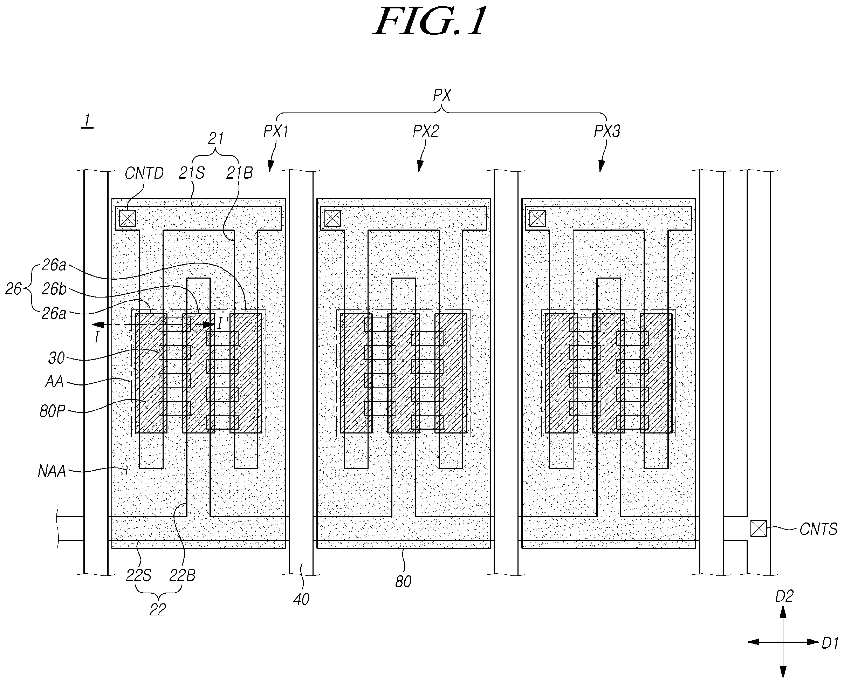

FIG. 1 is a plan view illustrating a display device 1 according to an embodiment.

Referring to FIG. 1, a display device 1 may include a plurality of pixels PX. Each of the pixels PX may include one or more light emitting elements 30 emitting light of a specific wavelength band to display a specific color. For example, each of the plurality of pixels PX may include a first subpixel PX1, a second subpixel PX2, and a third subpixel PX3.

The first subpixel PX1 may emit light of a first color, the second subpixel PX2 may emit light of a second color, and the third subpixel PX3 may emit light of a third color. The first color may be red, the second color may be green, and the third color may be blue, but the disclosure is not limited thereto, and each subpixel PXn may emit light of the same color. Further, although FIG. 1 illustrates that each of the pixels PX includes three subpixels, the disclosure is not limited thereto, and each of the pixels PX may include a larger number of subpixels.

The subpixel PXn of the display device 1 may include a predetermined area defined as an alignment area AA and a non-alignment area NAA. The alignment area AA may be defined as an area in which the light emitting element 30 included in the display device 1 is disposed. The non-alignment area NAA is an area other than the alignment area AA, and may be defined as an area in which the light emitting element 30 is not disposed and no light is emitted. However, the definition of the alignment area AA is not limited thereto, and may be defined as an area in which the light emitting element 30 should be disposed. In other words, the alignment area AA in which the light emitting element 30 is to be aligned may be defined on each pixel PX or the subpixel PXn, and the light emitting elements 30 may be disposed on the alignment area AA in a manufacturing process of the display device 1. For example, as illustrated in FIG. 1, the alignment area AA may include a partial area of the electrodes 21 and 22 of each subpixel PXn and a predetermined area between the electrodes 21 and 22 of each subpixel PXn.

The display device 1 may include a coating layer 80 disposed in at least a partial area of each pixel PX or subpixel PXn. The coating layer 80 may be disposed on the alignment area AA or the non-alignment area NAA of each subpixel PXn, and may partially overlap the electrodes 21 and 22 in some cases. For example, as illustrated in FIG. 1, the coating layer 80 may be disposed in each subpixel PXn to entirely cover the electrodes 21 and 22. For example, the coating layer 80 may include an opening 80P exposing a partial area. The coating layer 80 may include the alignment area AA and may be partially disposed in the non-alignment area NAA, but is not limited thereto.

The coating layer 80 according to an embodiment may perform a function of preventing the ink S injected into each pixel PX or the subpixel PXn from moving or spreading to an area other than the required alignment area AA. In the manufacturing process of the display device 1, the light emitting element 30 may be supplied to the electrodes 21 and 22, and the light emitting element 30 may be disposed on the electrodes 21 and 22 by electrophoresis or dielectrophoresis. For example, the light emitting element 30 may be seated in the alignment area AA required by the coating layer 80, and the light emitting element 30 may be smoothly disposed on the electrodes 21 and 22.

The subpixel PXn of the display device 1 may include a plurality of partition walls 40, a plurality of electrodes 21 and 22, a light emitting element 30, and a coating layer 80. The plurality of electrodes 21 and 22 may be electrically connected to the light emitting elements 30. The plurality of electrodes 21 and 22 may receive a predetermined voltage so that the light emitting element 30 emits light. The plurality of electrodes 21 and 22 may be utilized to form an electric field in the subpixel PXn to align the light emitting element 30.

The plurality of electrodes 21 and 22 may include a first electrode 21 and a second electrode 22. In an embodiment, the first electrode 21 may be a pixel electrode separated for each subpixel PXn, and the second electrode 22 may be a common electrode commonly connected along each subpixel PXn. For example, one of the first electrode 21 and the second electrode 22 may be an anode electrode of the light emitting element 30, and the other may be a cathode electrode of the light emitting element 30. However, the types of the first electrode 21 and the second electrode 22 are not limited thereto, and vice versa.

The first electrode 21 and the second electrode 22, respectively, may include electrode stem portions 21S and 22S disposed to extend in the first direction D1 and at least one electrode branch portion 21B and 22B extending and branching from the electrode stem portions 21S and 22S in the second direction D2, which is a direction crossing the first direction D1.

The first electrode 21 may include a first electrode stem portion 21S extending in the first direction D1 and at least one first electrode branch portion 21B branched from the first electrode stem portion 21S and extending in the second direction D2. Two opposite ends of the first electrode stem portion 21S of any one pixel may be spaced apart between subpixels PXn and terminated, but may be placed on substantially the same straight line as the first electrode stem portion 21S of a neighboring subpixel belonging to the same row (e.g., adjacent in the first direction D1). Accordingly, the first electrode stem portion 21S disposed in each subpixel PXn may apply a different electrical signal to each first electrode branch portion 21B, and each first electrode branch portion 21B may be driven separately.

The first electrode branch portion 21B may be branched from at least a portion of the first electrode stem portion 21S, may be disposed to extend in the second direction D2, and may be terminated while being spaced apart from the second electrode stem portion 22S disposed to face the first electrode stem portion 21S. The second electrode 22 may include a second electrode stem portion 22S extending in the first direction D1 to be spaced apart from the first electrode stem portion 21S and disposed to face the first electrode stem portion 21S, and a second electrode branch portion 22B branched from the second electrode stem portion 22S and disposed to extend in the second direction D2. However, the other end of the second electrode stem part 22S may extend to a plurality of subpixels PXn adjacent in the first direction D1. Accordingly, two opposite ends of any one pixel second electrode stem portion 22S may be connected to the second electrode stem portion 22S of a neighboring pixel between the pixels PX.

The second electrode branch portion 22B may be spaced apart from and face the first electrode branch portion 21B, and may be terminated while being spaced apart from the first electrode stem portion 21S. In other words, one end of the second electrode branch portion 22B may be connected to the second electrode stem portion 22S, and the other end of the second electrode branch portion 22B may be disposed in the subpixel PXn while being spaced apart from the first electrode stem portion 21S. In the drawings, two first electrode branch portions 21B are disposed, and a second electrode branch portion 22B is disposed between the two first electrode branch portions 21B, but the disclosure is not limited thereto.

A plurality of partition walls 40 may be disposed at a boundary between the subpixels PXn. The respective end portions of the plurality of first electrode stem portions 21S may be terminated while being spaced apart from each other with respect to the partition wall 40. The partition wall 40 may extend in the second direction D2 and may be disposed at a boundary of the subpixels PXn arranged in the first direction D1. However, the disclosure is not limited thereto, and the partition wall 40 may be disposed at a boundary of the subpixels PXn extending in the first direction D1 and arranged in the second direction D2.

A plurality of light emitting elements 30 may be aligned between the first electrode branch portion 21B and the second electrode branch portion 22B. At least some of the plurality of light emitting elements 30 may have one end portion electrically connected to the first electrode branch portion 21B and the other end portion electrically connected to the second electrode branch portion 22B.

The plurality of light emitting elements 30 may be spaced apart from each other in the second direction D2 and may be aligned substantially parallel to each other. The spacing between the light emitting elements 30 is not particularly limited. In some cases, the plurality of light emitting elements 30 may be arranged adjacent to each other to form a group, and other plurality of light emitting elements 30 may form a group in a state of being spaced apart from each other by a predetermined interval, have a non-uniform density, and may be aligned in one direction.

Contact electrodes 26 may be disposed on the first electrode branch portion 21B and the second electrode branch portion 22B, respectively. However, the contact electrode 26 may be disposed substantially on an insulation layer, and at least a portion of the contact electrode 26 may contact or electrically connect to the first electrode branch portion 21B and the second electrode branch portion 22B. The plurality of contact electrodes 26 may be disposed to extend in the second direction D2 and may be disposed to be spaced apart from each other in the first direction D1. The contact electrode 26 may contact at least one end portion of the light emitting element 30, and the contact electrode 26 may contact the first electrode 21 or the second electrode 22 to receive an electrical signal. Accordingly, the contact electrode 26 may transfer an electrical signal transferred from each of the electrodes 21 and 22 to the light emitting element 30.

The contact electrode 26 may include a first contact electrode 26a and a second contact electrode 26b. The first contact electrode 26a may be disposed on the first electrode branch portion 21B, may contact one end portion of the light emitting element 30, and the second contact electrode 26b may be disposed on the second electrode branch portion 22B, and may contact the other end portion of the light emitting element 30.

The first electrode stem portion 21S and the second electrode stem portion 22S may be electrically connected to a circuit element layer of the display device 1 through contact holes, e.g., the first electrode contact hole CNTD and a second electrode contact hole CNTS, respectively. FIG. 1 illustrates that one second electrode contact hole CNTS is formed in the second electrode stem portion 22S of the plurality of subpixels PXn. However, the position and number of the second electrode contact holes CNTS are not limited thereto, and in some cases, the second electrode contact hole CNTS may be formed for each subpixel PXn.

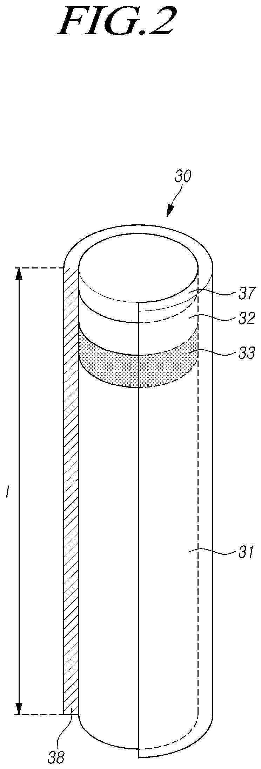

FIG. 2 illustrates a light emitting element 30 according to an embodiment.

The light emitting element 30 may be a light emitting diode, and specifically, the light emitting element 30 may be an inorganic light emitting element having a micrometer or nanometer size and formed of an inorganic material. When an electric field is formed between two electrodes facing each other in a specific direction, the inorganic light emitting diode may be aligned between the two electrodes in which polarity is formed. The light emitting element 30 may be aligned between the electrodes by the electric field formed on the two electrodes. The light emitting element 30 may include semiconductor crystals doped with any conductivity-type (e.g., p-type or n-type) impurities. The semiconductor crystal may receive an electrical signal applied from an external power source and emit the electrical signal as light in a specific wavelength band.

Referring to FIG. 2, the light emitting element 30 according to an embodiment may include a first conductivity-type semiconductor 31, a second conductivity-type semiconductor 32, an active layer 33, and an insulation film 38. Further, the light emitting element 30 according to an embodiment may further include at least one conductive electrode layer 37. FIG. 2 illustrates that the light emitting element 30 further includes one conductive electrode layer 37, but is not limited thereto. In some cases, the light emitting element 30 may include a larger number of conductive electrode layers 37 or may be omitted.

The light emitting element 30 may have a shape extending in one direction. The light emitting element 30 may have a shape such as a nanorod, a nanowire, or a nanotube. In an embodiment, the light emitting element 30 may be cylindrical or rod-shaped. However, the shape of the light emitting element 30 is not limited thereto, and may have various shapes such as a cube, a rectangular parallelepiped, and a hexagonal columnar shape. A plurality of semiconductors included in the light emitting element 30 to be described below may be sequentially disposed or stacked along the one direction.

The light emitting element 30 according to an embodiment may emit light of a specific wavelength band. In an embodiment, the light emitted from the active layer 33 may emit blue light having a central wavelength band in a range from 450 nm to 495 nm. However, the central wavelength band of the blue light is not limited to the above-described range, and it should be understood that the central wavelength band of the blue light includes all wavelength ranges that may be recognized as blue in the art. Further, the light emitted from the active layer 33 of the light emitting element 30 is not limited thereto, and may be green light having a central wavelength band in a range of 495 nm to 570 nm or red light having a central wavelength band in a range of 620 nm to 750 nm.

Referring to FIG. 2, when the light emitting element 30 is described in detail, the first conductivity-type semiconductor 31 may be, e.g., an n-type semiconductor having a first conductivity type. For example, when the light emitting element 30 emits light in the blue wavelength band, the first conductivity-type semiconductor 31 may include a semiconductor material having a chemical formula of InxAlyGa1 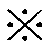 yN (0≤x≤1,0≤y≤1, 0≤x+y≤1). For example, it may be any one or more of n-type doped InAlGaN, GaN, AlGaN, InGaN, AlN, and InN. The first conductivity-type semiconductor 31' may be doped with a first conductive dopant, and for example, the first conductive dopant may be Si, Ge, Sn, or the like. In an embodiment, the first conductivity-type semiconductor 31 may be n-GaN doped with n-type Si. The length of the first conductivity-type semiconductor 31 may range from 1.5 µm to 5 µm, but is not limited thereto.

The second conductivity-type semiconductor 32 may be disposed on the active layer 33. The second conductivity-type semiconductor 32 may be, e.g., a p-type semiconductor having a second conductivity type. For example, when the light emitting element 30 emits light in a blue or green wavelength band, the second conductivity-type semiconductor 32 may include a semiconductor material having a chemical formula of InxAlyGal 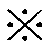 yN (0≤x≤1,0≤y≤1, 0≤x+y≤1). For example, it may be any one or more of p-type doped InAlGaN, GaN, AlGaN, InGaN, AlN, and InN. The second conductive type semiconductor 32 may be doped with a second conductive dopant, and for example, the second conductive dopant may be Mg, Zn, Ca, Se, Ba, or the like. In an embodiment, the second conductivity-type semiconductor 32 may be p-GaN doped with p-type Mg. The length of the second conductivity-type semiconductor 32 may range from 0.08 µm to 0.25 µm, but is not limited thereto. The drawings illustrate that the first conductivity-type semiconductor 31 and the second conductivity-type semiconductor 32 are composed of one layer, but are not limited thereto. In some cases, depending on the material of the active layer 33, the first conductivity-type semiconductor 31 and the second conductivity-type semiconductor 32 may further include a larger number of layers, e.g., a clad layer or a tensile strain barrier reducing (TSBR) layer.

The active layer 33 may be disposed between the first conductivity-type semiconductor 31 and the second conductivity-type semiconductor 32. The active layer 33 may include a material having a single or multi-quantum well structure. When the active layer 33 includes a material having a multi-quantum well structure, a quantum layer and a well layer may be alternately stacked. The active layer 33 may emit light by coupling an electron-hole pair according to an electrical signal applied through the first conductivity-type semiconductor 31 and the second conductivity-type semiconductor 32. For example, when the active layer 33 emits light in the blue wavelength band, the active layer 33 may include a material such as AlGaN, AlInGaN, or the like. When the active layer 33 is a multi-quantum well structure in which the quantum layer and the well layer are alternately stacked, the quantum layer may include a material such as AlGaN or AlInGaN, and the well layer may include a material such as GaN or AlInN. In an embodiment, the active layer 33 may include AlGaInN as the quantum layer and AlInN as the well layer, and as described above, the active layer 33 may emit blue light having a central wavelength band in a range of 450 nm to 495 nm. However, the disclosure is not limited thereto, and the active layer 33 may be a structure in which a type of semiconductor material having a large band gap energy and a type of semiconductor material having a small band gap energy are alternately stacked with each other, or may include Group 3 to Group 5 semiconductor materials different according to the wavelength band of light emitted. The light emitted by the active layer 33 is not limited to light in the blue wavelength band, and may emit light in the red and green wavelength bands in some cases. The length of the active layer 33 may range from 0.05 µm to 0.25 µm, but is not limited thereto. The light emitted from the active layer 33 may be emitted to both side surfaces as well as the lengthwise outer surface of the light emitting element 30. The directivity of the light emitted from the active layer 33 is not limited to one direction.

The conductive electrode layer 37 may be an ohmic contact electrode. However, the disclosure is not limited thereto, but it may be a Schottky contact electrode. The conductive electrode layer 37 may include a conductive metal. For example, the conductive electrode layer 37 may include at least one of aluminum (Al), titanium (Ti), indium (In), gold (Au), silver (Ag), indium tin oxide (ITO), indium zinc oxide (IZO), and indium tin-zinc oxide (ITZO). Further, the conductive electrode layer 37 may include a semiconductor material doped with an n-type or a p-type impurity. The conductive electrode layer 37 may include the same material and may include different materials, but is not limited thereto.

The insulation film 38 may be disposed to surround the outer surfaces of the plurality of semiconductors described above. In an embodiment, the insulation film 38 may be disposed to surround at least an outer surface of the active layer 33, and may extend in one direction in which the light emitting element 30 extends. The insulation film 38 may function to protect the members. For example, the insulation film 38 may be formed to surround the side portions of the members, and to expose two opposite end portions of the light emitting element 30 in the length direction. The drawings illustrate that the insulation film 38 is formed to extend in the length direction of the light emitting element 30 to cover the first conductivity-type semiconductor 31 to the conductive electrode layer 37, but the disclosure is not limited thereto. The insulation film 38 may cover only the outer surface of some conductivity-type semiconductors, including the active layer 33, or may cover only a portion of the outer surface of the conducive electrode layer 37 so that a partial outer surface of the conductive electrode layer 37 may be exposed. The thickness of the insulation film 38 may range from 10 nm to 1.0 µm, but is not limited thereto. The thickness of the insulation film 38 may be 40 nm. The insulation film 38 may include materials having insulating properties, e.g., silicon oxide (SiOx), silicon nitride (SiNx), silicon oxynitride (SiOxNy), aluminum nitride (AlN), aluminum oxide (Al2O3), and the like. Accordingly, it may be possible to prevent an electrical short circuit that may occur when the active layer 33 directly contacts the electrode where an electrical signal is transferred to the light emitting element 30. Further, since the insulation film 38 protects the outer surface of the light emitting element 30, including the active layer 33, it may be possible to prevent a decrease in luminous efficiency. Further, according to an embodiment, the outer surface of the insulation film 38 may be surface-treated.

The light emitting element 30 may be supplied to the fluid layer when the display device 1 is manufactured. For example, the light emitting element 30 may move from the fluid layer toward the electrodes 21 and 22 and may be aligned with the electrodes 21 and 22 by electrophoresis or dielectrophoresis. Here, the surface of the insulation film 38 may be subjected to hydrophobic or hydrophilic treatment to maintain the dispersed state without agglomerating with other adjacent light emitting elements 30 in the fluid layer.

The light emitting element 30 may have a length (1) in a range of 1 µm to 10 µm or 2 µm to 5 µm, and preferably may have a length of about 4 µm. Further, the diameter of the light emitting element 30 may range from 300 nm to 700 nm, and the aspect ratio of the light emitting element 30 may be 1.2 to 100. However, the disclosure is not limited thereto, and the plurality of light emitting elements 30 included in the display device 1 may have different diameters depending on the composition differences of the active layer 33. For example, the diameter of the light emitting element 30 may have a range of about 500 nm.

As described above, the light emitting element 30 may be supplied to the fluid layer and may be aligned on the electrodes 21 and 22 by electrophoresis or dielectrophoresis. For example, the light emitting element 30 may be seated in the alignment area AA by electrophoresis or dielectrophoresis, and thus may be disposed between the predetermined electrodes 21 and 22.

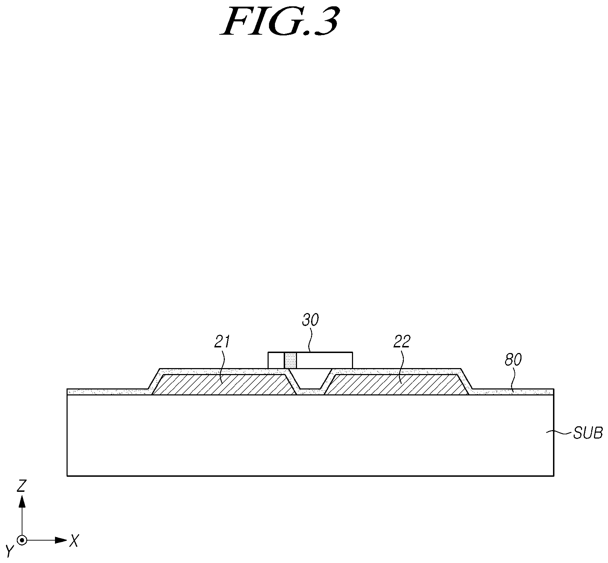

FIG. 3 is a cross-sectional view illustrating a display device 1 according to an embodiment.

Referring to FIGS. 1 to 3, a display device 1 may include a light emitting element 30 aligned on at least one electrode 21 or 22. For example, in the manufacturing process of the display device 1, at least one electrode 21 or 22 may be formed on a base substrate SUB. The base substrate SUB may include an alignment area AA and a non-alignment area NAA. The light emitting element 30 may be aligned with at least one electrode 21 or 22. Although the alignment area AA and the non-alignment area NAA are illustrated in 2-dimensions, the disclosure is not limited thereto. For instance, the alignment area AA and the non-alignment area NAA may extend in a vertical direction above the base substrate SUB.

In an embodiment, a coating layer 80 may be formed on the at least one electrode 21 or 22. For example, the light emitting element 30 may be disposed between the first electrode 21 and the second electrode 22 on the coating layer 80. When the display device 1 is manufactured, the coating layer 80 disposed on the electrodes 21 and 22 may prevent the transferred light emitting element 30 from spreading in the fluid layer, thereby leading the light emitting element 30 to be smoothly disposed in the alignment area AA on the base substrate SUB.

The light emitting element 30 may be aligned between the first electrode 21 and the second electrode 22 to receive an electrical signal applied from an external power source. The light emitting element may emit light of a specific wavelength band based on the electrical signal. The light emitting element 30 may be aligned in a specific orientation direction between the first electrode 21 and the second electrode 22. For example, as illustrated in FIG. 3, the light emitting element 30 may be horizontally aligned between the first electrode 21 and the second electrode 22. For example, unlike FIG. 3, the light emitting element 30 may be vertically aligned between the first electrode 21 and the second electrode 22.

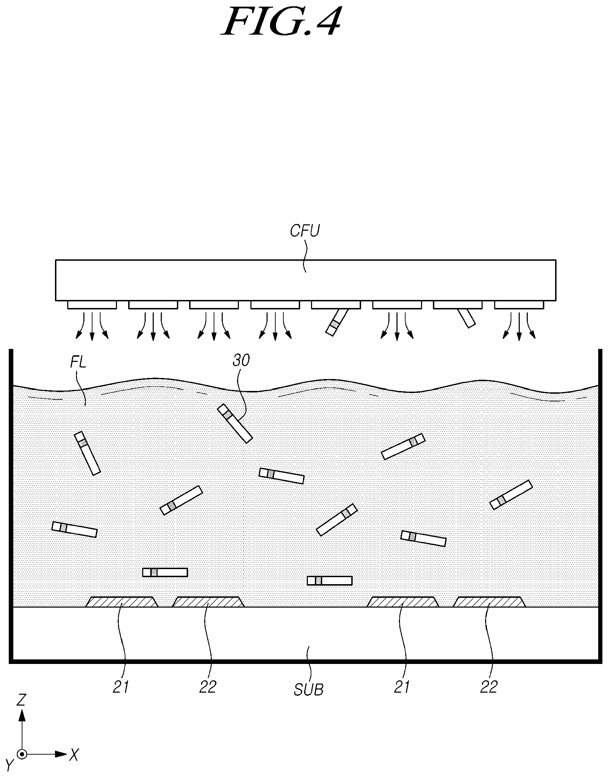

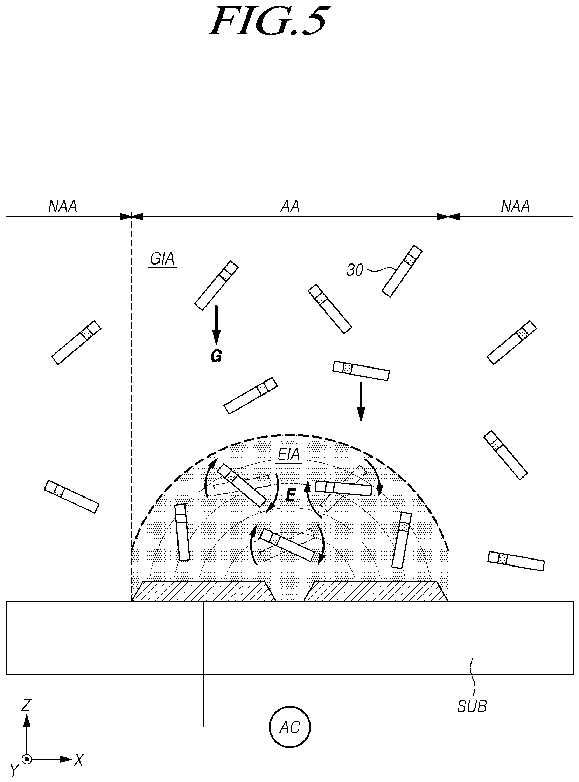

FIG. 4 illustrates a transfer process of a light emitting element 30 according to an embodiment, and FIG. 5 illustrates a force received by a light emitting element 30 in an alignment process according to an embodiment.

Referring to FIG. 4, during the transfer process, the light emitting element 30 may be supplied to the fluid layer FL and may be aligned with the at least one electrode 21 or 22 by moving from the fluid layer FL toward the at least one electrode 21 or 22. For example, the transfer process may be performed using a receiving chamber receiving the base substrate SUB and the fluid layer FL, and a chip feeding unit CFU disposed above the receiving chamber.

The light emitting element 30 may be discharged from the chip feeding unit (CFU) to be supplied to the fluid layer FL. The chip feeding unit CFU may include at least one supply nozzle for discharging the light emitting element 30. For example, the supply nozzle may discharge the light emitting element 30 to the fluid layer FL through a plurality of supply lines. During the transfer process, the chip feeding unit CFU may be disposed on the fluid layer FL and may discharge the light emitting element 30 in a vertical downward direction. For example, the chip feeding unit CFU may discharge the light emitting element 30 to the receiving chamber filled with the fluid layer FL. The receiving chamber may include a base substrate SUB on which the at least one electrode 21 or 22 is formed and a fluid layer FL filling on the base substrate SUB.

The fluid layer FL may include a fluid for aligning the light emitting element 30 to the at least one electrode 21 or 22. The fluid may include at least one of a hydrophobic fluid and a hydrophilic fluid. The light emitting element 30 may move in the fluid layer FL. For example, the light emitting element 30 may move based on at least one of gravity and an electric field in the fluid layer FL.

Referring to FIG. 5, in the fluid layer FL, the light emitting element 30 may be aligned with the at least one electrode 21 or 22 by receiving a force by at least one of gravity G and an electric field E.

In an embodiment, the light emitting element 30 may be lowered toward the at least one electrode 21 or 22 by gravity G in the gravitational field area GIA of the fluid layer FL. For example, the light emitting element 30 supplied to the fluid layer FL may sink vertically downward in any one of the alignment area AA and the non-alignment area NAA of the base substrate SUB. When the light emitting element 30 moves vertically downward in the alignment area AA, the light emitting element 30 may be aligned with the at least one electrode 21 or 22. A light emitting element 30 which moves vertically downward in the alignment area AA may be referred to as a first light emitting element. When the light emitting element 30 moves vertically downward in the non-alignment area NAA, the light emitting element 30 may be a dummy light emitting element 30_D that is not aligned with the at least one electrode 21 or 22. A light emitting element 30 moves vertically downward in the non-alignment area NAA may be referred to as a second light emitting element.

In an embodiment, the light emitting element 30 may be aligned with the at least one electrode 21 or 22 in the electric field area EIA formed in the at least one electrode 21 or 22. For example, the at least one electrode 21 or 22 may form an electric field E by applying AC power AC. The light emitting element 30 may be stably fixed to the at least one electrode 21 or 22 in at least one of an electrophoresis method based on an electric field and a dielectrophoresis method based on an electric field.

For example, the light emitting element 30 may be rotated by electrophoretic force. In this case, one end having a positive charge of the light emitting element 30 moves to the negative electrode of the at least one electrode 21 or 22, and the other end having a negative charge of the light emitting element 30 moves to the positive electrode of the at least one electrode 21 or 22, so that the light emitting element 30 may rotate in a predetermined direction in the electric field area EIA. In other words, the light emitting element 30 may be disposed between the at least one electrode 21 and 22 as the orientation direction and position are changed by the electrophoretic force.

For example, the light emitting element 30 may be rotated by a dielectrophoretic force. In this case, one end and the other end of the light emitting element 30 may have a predetermined polarity by dielectric polarization. For example, the degree of dielectric polarization of the light emitting element 30 may vary in proportion to the intensity of the electric field E. The dielectrically polarized one end and other end of the light emitting element 30 may rotate in the electric field area EIA according to the direction of the electric field E. In other words, the light emitting element 30 may be disposed between the at least one electrode 21 and 22 while the orientation direction and the position thereof are changed by the dielectrophoretic force.

As illustrated in FIG. 5, the light emitting element 30 lowered to the non-alignment area NAA on the base substrate SUB may not be aligned with the at least one electrode 21 or 22. The light emitting element 30 of the non-alignment area NAA may be a dummy light emitting element 30_D (e.g., a second light emitting element). Since the dummy light emitting element 30_D may not output light from the display device, the dummy light emitting element 30_D may be removed or recovered by a separate process after the transfer process. For example, during the transfer process, the higher the ratio of the dummy light emitting elements 30_D to the light emitting elements 30 is, the lower the transfer yield may be. The alignment structure and the display manufacturing method using the alignment structure of the disclosure may move the dummy light emitting element 30_D of the non-alignment area NAA to the alignment area AA, thereby minimizing the dummy light emitting elements 30_D that are removed or recovered and increasing the transfer yield.

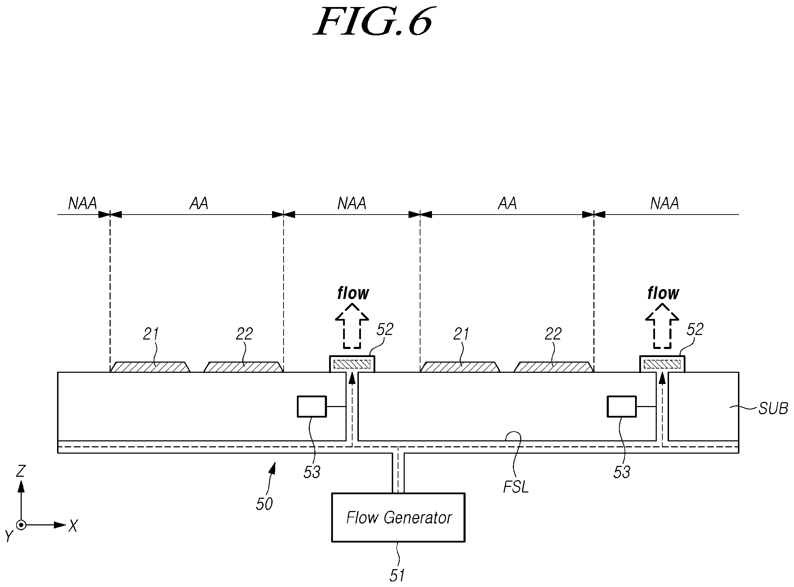

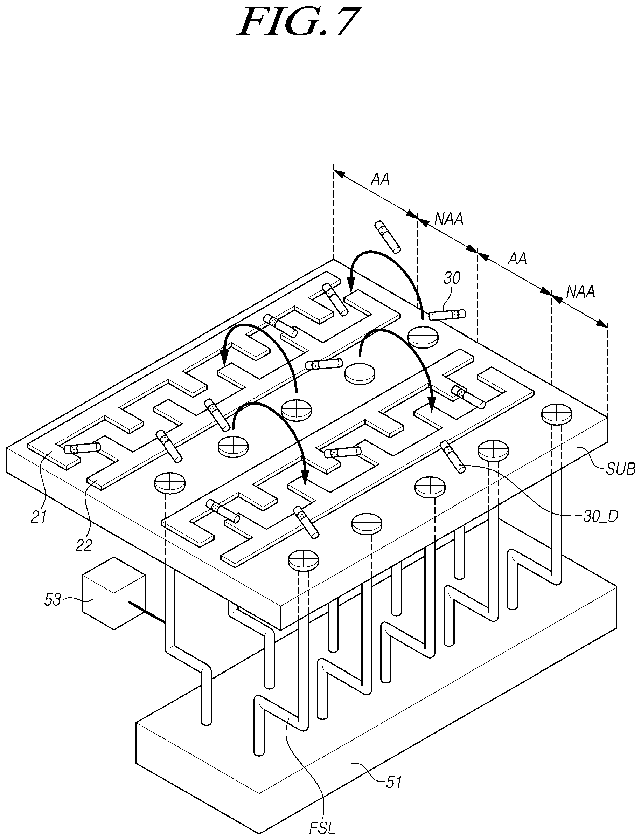

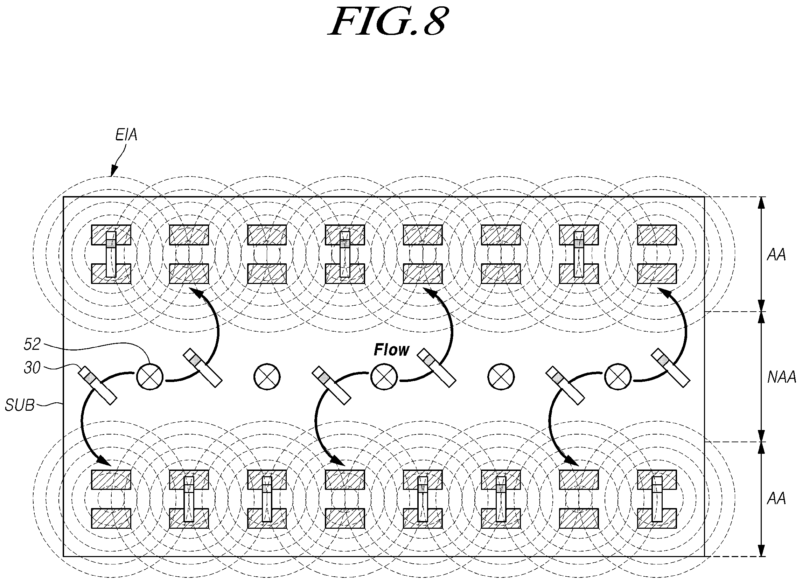

FIG. 6 is a cross-sectional view illustrating an alignment structure of a light emitting element 30 according to an embodiment, FIG. 7 is a perspective view illustrating an alignment structure of a light emitting element 30 according to an embodiment, and FIG. 8 is a view illustrating a light emitting element 30 moving from a non-alignment area NAA to an alignment area AA according to an embodiment.

Referring to FIGS. 6 and 7, an alignment structure may include a base substrate SUB where an alignment area AA and a non-alignment area NAA are defined, at least one electrode 21 and 22 formed on the base substrate SUB, and a flow supply apparatus 50 formed under the base substrate SUB. For example, the light emitting element 30 may move toward the at least one electrode 21 or 22 in the alignment area AA, in the fluid layer FL, and may be aligned with the at least one electrode 21 or 22 based on an electric field.

In an embodiment, the at least one electrode 21 or 22 may be formed on the base substrate SUB. For example, the at least one electrode 21 or 22 may be formed in the alignment area AA on the base substrate SUB. The at least one electrode 21 or 22 may align the light emitting element 30 and may be electrically connected to the light emitting element 30. For example, the light emitting element 30 may be aligned with the at least one electrode 21 or 22 by being lowered in a vertical direction by gravity in the gravitational influence zone of the fluid layer FL and rotating by at least one of electrophoresis and dielectrophoresis in the electric field influence zone of the fluid layer FL.

In an embodiment, the flow supply apparatus 50 may move the light emitting element 30 in the non-alignment area NAA to the alignment area AA by supplying a flow to the fluid layer FL. For example, the flow supply apparatus 50 may align the dummy light emitting element 30_D to the at least one electrode 21 or 22 of the alignment area AA by moving the dummy light emitting element 30_D lowered from the non-alignment area NAA to at least one of the gravitational influence zone and the electric field influence zone of the alignment area AA.

The flow supply apparatus 50 may include a flow generator 51 generating a flow using a flow medium, a flow injector 52 injecting the flow transferred to the flow supply line FSL into the fluid layer FL, and a flow controller 53 measuring the flow of the flow supply line FSL and controlling the flow. For example, the flow generated from the flow generator 51 disposed under the base substrate SUB may be transferred to the flow injector 52 through the flow supply line FSL, and may be injected into the fluid layer FL through the flow injector 52 formed upward of the base substrate SUB.

The flow generator 51 may generate the flow using the flow medium. For example, the flow medium may be the same liquid as the fluid contained in the fluid layer FL. For example, the flow medium may be a gas that does not react with the fluid contained in the fluid layer FL. The flow generator 51 may generate the flow by outputting the flow medium including at least one of liquid and gas to the flow supply line FSL at a predetermined speed. For example, the flow generator 51 may be at least one of a circulator for circulating liquid and gas, a gas inlet for supplying gas to the receiving chamber, or a fluid pump for moving liquid and gas.

The flow injector 52 may be formed upward of the base substrate SUB. For example, the flow injector 52 may be continuously disposed in the non-alignment area NAA of the base substrate SUB at intervals.

As illustrated in FIGS. 7 and 8, the flow injector 52 may be arranged in parallel with the direction in which the at least one electrode 21 and 22 of the alignment area AA extends in the non-alignment area NAA of the base substrate SUB. The flow injector 52 may inject the flow into the fluid layer FL by emitting the flow medium transferred through the flow supply line FSL to the fluid layer FL. For example, the flow may be injected toward the alignment area AA on the base substrate SUB. The flow supply line FSL may be formed through the base substrate SUB to transfer the flow medium from the flow generator 51 formed under the base substrate SUB to the flow injector 52. For example, the flow injector 52 may be formed on the base substrate SUB to have a height of 1 µm to 1000 µm. The flow injector 52 may include an injection port for injecting the flow medium into the fluid layer FL. The injection port may be formed in a predetermined shape and direction. For example, the intensity and direction of the flow supplied to the fluid layer FL may be determined based on the shape and direction of the injection port.

The flow controller 53 may measure the flow by calculating the speed of the flow medium transferred to the flow supply line FSL. For example, the flow controller 53 may include at least one of a mass flow controller (MFC), a magnetic flow meter, a laser doppler velocimetry (LDG), a volumetric flow meter, an ultrasonic flow meter, a vortex flow meter, or a differential pressure flow meter for measuring the speed of the flow medium.

The flow controller 53 may control the flow based on the measured flow. For example, the flow controller 53 may reduce or increase the flow by comparing the measured flow with a reference flow. For example, when the flow of the flow supply line FSL is faster than a predetermined reference flow, the flow controller 53 may reduce the flow. For example, when the flow of the flow supply line FSL is slower than the predetermined reference flow, the flow controller 53 may increase the flow. Here, the reference flow may be changed according to a setting. For example, the reference flow may be changed considering at least one of the size of the alignment structure, the arrangement of the at least one electrode 21 and 22, the size of the light emitting element 30, the type of fluid in the fluid layer FL, and the type of flow medium.

As shown in FIG. 8, some (e.g., the dummy light emitting element 30_D) of the light emitting elements 30 supplied to the fluid layer FL may be lowered to the non-alignment area NAA. The flow supply apparatus 50 may move the light emitting element 30 (e.g., the dummy light emitting element 30_D) lowered to the non-alignment area NAA to the alignment area AA by injecting a flow of a predetermined intensity and direction into the fluid layer FL through the flow injector 52. For example, the light emitting element 30 may move to at least one of the gravitational field area GIA and the electric field area EIA of the alignment area AA based on the flow injected from the flow injector 52. In this case, as the dummy light emitting element 30_D moves to the alignment area AA based on the flow, the dummy light emitting element 30_D may also be aligned with the at least one electrode 21 or 22 by the force of gravity and the electric field. Accordingly, the alignment structure of the light emitting element 30 and the method for manufacturing the display device using the alignment structure of the light emitting element 30 of the disclosure may increase the transfer yield of the light emitting element 30 by increasing the probability that the light emitting element 30 of the fluid layer FL is aligned with the electrode.

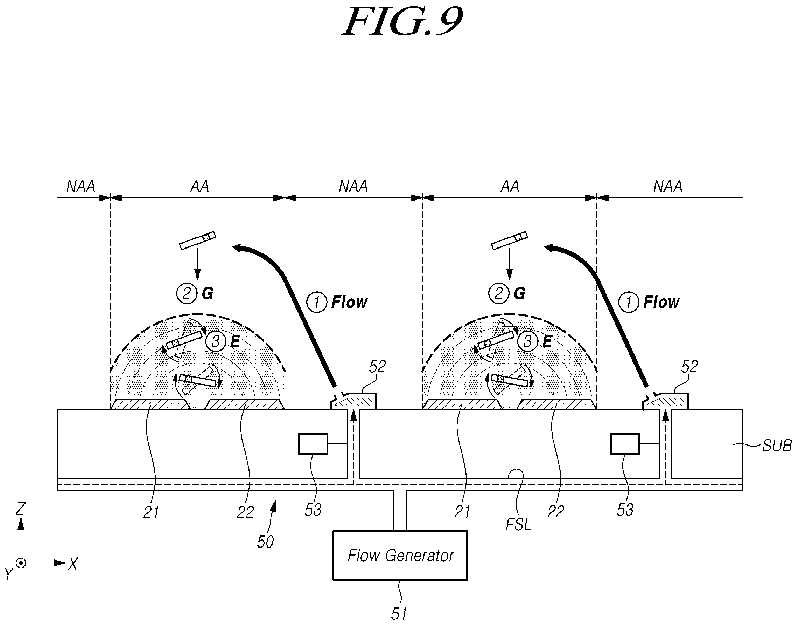

FIG. 9 illustrates a flow supply apparatus 50 for supplying a flow in one direction to a fluid layer FL according to an embodiment.

Referring to FIG. 9, the flow supply apparatus 50 may move the light emitting element 30 of the non-alignment area NAA to the alignment area AA by supplying the flow in one direction of the fluid layer FL. The flow generator 51 may generate the flow by outputting the flow medium to the flow supply line FSL at a predetermined speed. The flow injector 52 may inject the flow into the fluid layer FL by emitting the flow medium transferred through the flow supply line FSL to the fluid layer FL.

In an embodiment, the flow injector 52 may include an injection port for injecting the flow medium into the fluid layer FL. The intensity and direction of the flow supplied to the fluid layer FL may be determined based on the shape and direction of the injection port. As shown in FIG. 9, the flow injector 52 may include an injection port for injecting the flow medium in one direction. For example, the flow injector 52 may supply the flow in one direction to the fluid layer FL using the injection port, thereby moving the dummy light emitting element 30_D of the non-alignment area NAA to the at least one alignment area AA adjacent to the non-alignment area NAA.

For example, the light emitting element 30 (e.g., the dummy light emitting element 30_D) lowered to the non-alignment area NAA may move to the gravitational field area of the adjacent alignment area AA by the flow Flow in one direction injected from the flow injector 52. The light emitting element 30 may be lowered vertically downward by gravity G in the gravitational field area of the alignment area AA. The light emitting element 30 may rotate in a specific direction by the electric field E in the electric field area of the alignment area AA. For example, the light emitting element 30 may be aligned with the at least one electrode 21 or 22 in at least one of electrophoresis and dielectrophoresis in the electric field area.

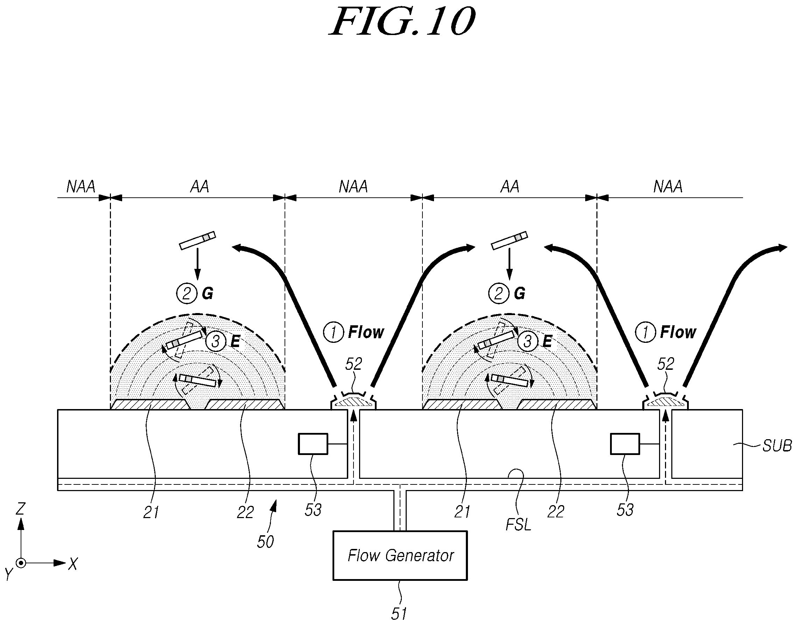

FIG. 10 illustrates a flow supply apparatus 50 for supplying flows in both directions to a fluid layer FL according to an embodiment.

Referring to FIG. 10, the flow supply apparatus 50 may move the light emitting element 30 of the non-alignment area NAA to the alignment area AA by supplying flows in both directions of the fluid layer FL. The flow generator 51 may generate the flow by outputting the flow medium to the flow supply line FSL at a predetermined speed. The flow injector 52 may inject the flow into the fluid layer FL by emitting the flow medium transferred through the flow supply line FSL to the fluid layer FL.

In an embodiment, the flow injector 52 may include an injection port for injecting the flow medium into the fluid layer FL. The intensity and direction of the flow supplied to the fluid layer FL may be determined based on the shape and direction of the injection port. As shown in FIG. 10, the flow injector 52 may include two injection ports for injecting the flow medium in a first direction and a second direction opposite to the first direction. For example, the flow injector 52 may supply the flow in both directions to the fluid layer FL using the injection ports, thereby moving the dummy light emitting element 30_D of the non-alignment area NAA to the at least one alignment area AA adjacent to the non-alignment area NAA.

For example, the light emitting element 30 (e.g., the dummy light emitting element 30_D) lowered to the non-alignment area NAA may move to the gravitational field area of at least one adjacent alignment area AA by the flow Flow in the first direction and the second direction injected from the flow injector 52. The light emitting element 30 may be lowered vertically downward by gravity G in the gravitational field area of the alignment area AA. The light emitting element 30 may rotate in a specific direction by the electric field E in the electric field area of the alignment area AA. For example, the light emitting element 30 may be aligned with the at least one electrode 21 or 22 in at least one of electrophoresis and dielectrophoresis in the electric field area.

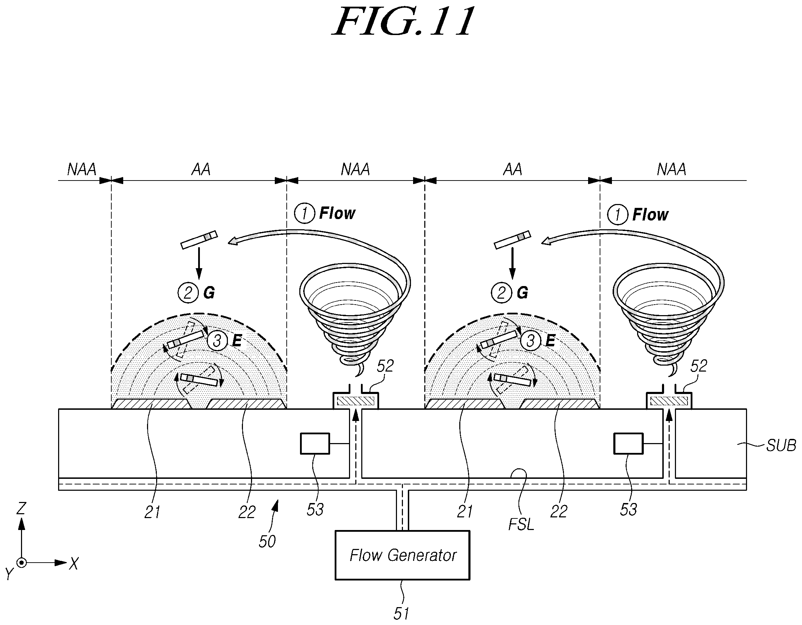

FIG. 11 illustrates a flow supply apparatus 50 for forming a vortex by supplying a flow to a fluid layer FL according to an embodiment.

Referring to FIG. 11, the flow supply apparatus 50 may form a vortex in the fluid layer FL to move the light emitting element 30 of the non-alignment area NAA to the alignment area AA. The flow generator 51 may generate the flow by outputting the flow medium to the flow supply line FSL at a predetermined speed. The flow injector 52 may inject the flow into the fluid layer FL by emitting the flow medium transferred through the flow supply line FSL to the fluid layer FL.

In an embodiment, the flow injector 52 may include an injection port for injecting the flow medium into the fluid layer FL. The intensity and direction of the flow supplied to the fluid layer FL may be determined based on the shape and direction of the injection port. As shown in FIG. 11, the flow injector 52 may include an injection port for forming a vortex in the fluid layer FL by injecting the flow medium. For example, the flow injector 52 may generate a vortex in at least one of a clockwise direction and a counterclockwise direction in the fluid layer FL by injecting the flow medium, and may move the dummy light emitting element 30_D of the non-alignment area NAA to the at least one alignment area AA adjacent to the non-alignment area NAA based on the vortex.

For example, the light emitting element 30 (e.g., the dummy light emitting element 30_D) lowered to the non-alignment area NAA may move to the gravitational field area of at least one adjacent alignment area AA by the vortex formed based on the flow Flow injected from the flow injector 52. The light emitting element 30 may be lowered vertically downward by gravity G in the gravitational field area of the alignment area AA. The light emitting element 30 may rotate in a specific direction by the electric field E in the electric field area of the alignment area AA. For example, the light emitting element 30 may be aligned with the at least one electrode 21 or 22 in at least one of electrophoresis and dielectrophoresis in the electric field area.

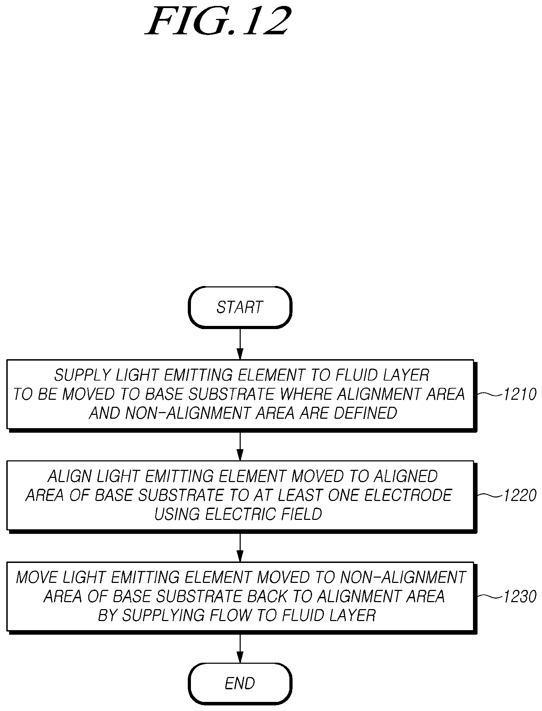

FIG. 12 illustrates a method for manufacturing a display device using an alignment structure according to an embodiment.

Referring to FIG. 12, a method for manufacturing a display device according to the disclosure may include forming at least one electrode 21 or 22 on a base substrate SUB and aligning a light emitting element 30 to the at least one electrode 21 or 22. Aligning the light emitting element 30 to the at least one electrode 21 or 22 may include supplying the light emitting element 30 to a fluid layer FL to be moved to the base substrate SUB where an alignment area AA and a non-alignment area NAA are defined (operation 1210), aligning the light emitting element 30 moved to the alignment area AA of the base substrate SUB to at least one electrode 21 or 22 using an electric field (operation 1220), and supplying a flow to the fluid layer FL to move the light emitting element 30 moved to the non-alignment area NAA of the base substrate SUB back to the alignment area AA (operation "230)'

According to an embodiment, in operation 1210, supplying the light emitting element 30 to the fluid layer FL to be moved to the base substrate SUB where the alignment area AA and the non-alignment area NAA are defined may supply the light emitting element 30 to the fluid layer FL using a chip feeding unit CFU. The chip feeding unit CFU may include at least one supply nozzle for discharging the light emitting element 30. For example, the supply nozzle may discharge the light emitting element 30 to the fluid layer FL through a plurality of supply lines. During the transfer process, the chip feeding unit CFU may be disposed on the fluid layer FL and may discharge the light emitting element 30 in a vertical downward direction. For example, the chip feeding unit CFU may discharge the light emitting element 30 to the receiving chamber filled with the fluid layer FL. The receiving chamber may include a base substrate SUB on which the at least one electrode 21 or 22 is formed and a fluid layer FL filling on the base substrate SUB.

Further, in operation 1210, supplying the light emitting element 30 to the fluid layer FL to be moved to the base substrate SUB where that the alignment area AA and the non-alignment area NAA are defined may move the light emitting element 30 in a vertical downward direction based on gravity, in the fluid layer FL. The light emitting element 30 may be lowered toward the at least one electrode 21 or 22 on the base substrate SUB by the gravity G in the gravity field area GIA of the fluid layer FL. For example, the light emitting element 30 supplied to the fluid layer FL may sink vertically downward in any one of the alignment area AA and the non-alignment area NAA of the base substrate SUB. When the light emitting element 30 moves vertically downward in the alignment area AA, the light emitting element 30 may be aligned with the at least one electrode 21 or 22. When the light emitting element 30 moves vertically downward in the non-alignment area NAA, the light emitting element 30 may be a dummy light emitting element 30_D that is not aligned with the at least one electrode 21 or 22.

According to an embodiment, in operation 1220, aligning the light emitting element 30 moved to the alignment area AA of the base substrate SUB to the at least one electrode 21 or 22 using the electric field may align the light emitting element 30 to the at least one electrode 21 or 22 using at least one of an electrophoresis method based on the electric field and a dielectrophoresis method based on the electric field. For example, the light emitting element 30 may rotate in a predetermined direction in the electric field area EIA as one end having a positive charge of the light emitting element 30 moves to the negative electrode of the at least one electrode 21 or 22, and the other end having a negative charge of the light emitting element 30 moves to the positive electrode of the at least one electrode 21 or 22 by electrophoretic force. In other words, the light emitting element 30 may be disposed between the at least one electrode 21 and 22 as the orientation direction and position are changed by the electrophoretic force. One end and the other end of the light emitting element 30 may have a predetermined polarity by dielectric polarization. For example, the degree of dielectric polarization of the light emitting element 30 may vary in proportion to the intensity of the electric field E. For example, one end and the other end of the light emitting element 30 that are dielectrically polarized by the dielectrophoretic force may rotate in the electric field area EIA according to the direction of the electric field E. In other words, the light emitting element 30 may be disposed between the at least one electrode 21 and 22 while the orientation direction and the position thereof are changed by the dielectrophoretic force.

According to an embodiment, in operation 1230, supplying the flow to the fluid layer FL to move the light emitting element 30 moved to the non-alignment area NAA of the base substrate SUB back to the alignment area AA may align the light emitting element 30 to the at least one electrode 21 or 22 by moving the light emitting element 30 lowered to the non-alignment area NAA by gravity back to the alignment area. For example, the alignment structure may include a base substrate SUB where the alignment area AA and the non-alignment area NAA are defined, at least one electrode 21 and 22 formed on the base substrate SUB, and a flow supply apparatus 50 formed under the base substrate SUB. The flow supply apparatus 50 may supply the flow to the fluid layer FL to move the light emitting element 30 in the non-alignment area NAA to the alignment area AA. For example, the flow supply apparatus 50 may align the dummy light emitting element 30_D to the at least one electrode 21 or 22 of the alignment area AA by moving the dummy light emitting element 30_D lowered from the non-alignment area NAA to the alignment area AA.

As such, the alignment structure of the light emitting element 30 and the method for manufacturing the display device using the same according to the disclosure may move the dummy light emitting element 30_D of the non-alignment area NAA to the alignment area AA by supplying a flow to the fluid layer FL.

Accordingly, the alignment structure of the light emitting element 30 and the method for manufacturing the display device using the alignment structure of the light emitting element 30 of the disclosure may increase the transfer yield of the light emitting element 30 by increasing the probability that the light emitting element 30 of the fluid layer FL is aligned with the electrode. However, since this has been described above, no duplicate description is given.

The display device according to various embodiments of the disclosure may be one of various types of electronic devices. The display devices may include, for example, a portable communication device (e.g., a smartphone), a computer device, a portable multimedia device, a portable medical device, a camera, a wearable device, or a home appliance. The display devices according to an embodiment of the disclosure are not limited to the above-described devices.

It should be appreciated that various embodiments of the disclosure and the terms used therein are not intended to limit the technological features set forth herein to particular embodiments and include various changes, equivalents, or replacements for a corresponding embodiment. As used herein, the singular forms "a," "an," and "the" are intended to include the plural forms as well, unless the context clearly indicates otherwise. As used herein, the term 'or' should be understood as encompassing any and all possible combinations by one or more of the enumerated items. As used herein, the terms "include," "have," "comprise," and the like are used merely to designate the presence of the feature, component, part, or a combination thereof described herein, but use of the term does not exclude the likelihood of presence or adding one or more other features, components, parts, or combinations thereof. As used herein, each of such phrases as "A or B," "at least one of A and B," "at least one of A or B," "A, B, or C," "at least one of A, B, and C," and "at least one of A, B, or C," may include all possible combinations of one or more of the items enumerated together corresponding to one of the phrases. As used herein, such terms as "1^{st}" and "2^{nd}," or "first" and "second" may be used to simply distinguish a corresponding component from another, and does not limit the components in other aspect (e.g., importance or order).

As used herein, the term "part" or "module" may include a unit implemented in hardware, software, or firmware, and may interchangeably be used with other terms, for example, "logic," "logic block," "part," or "circuitry". A part or module may be a single integral component, or a minimum unit or part thereof, adapted to perform one or more functions. For example, according to an embodiment, 'part' or 'module' may be implemented in a form of an application-specific integrated circuit (ASIC).

As used in various embodiments of the disclosure, the term "if" may be interpreted as "when," "upon," "in response to determining," or "in response to detecting," depending on the context. Similarly, "if A is determined" or "if A is detected" may be interpreted as "upon determining A" or "in response to determining A", or "upon detecting A" or "in response to detecting A", depending on the context.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A method of manufacturing a display device, the method comprising:
providing a plurality of light emitting elements to a base substrate through a fluid layer, the base substrate including an alignment area and a non-alignment area;
aligning a first light emitting element provided to the alignment area of the base substrate to at least one electrode using an electric field; and
moving a second light emitting element provided to the non-alignment area of the base substrate to the alignment area by applying a flow to the fluid layer.

2. The method of claim 1, wherein the providing the plurality of light emitting elements to the base substrate through the fluid layer comprises:
lowering at least one of the plurality of light emitting elements in a vertical direction by gravityin a gravitational influence zone of the fluid layer; and
rotating the at least one of the plurality of light emitting elements by at least one of electrophoresis and dielectrophoresis in an electric field influence zone of the fluid layer.

3. The method of claim 2, wherein the moving the second light emitting element provided to the non-alignment area of the base substrate to the alignment area by applying the flow to the fluid layer comprises:
aligning the second light emitting element to the at least one electrode of the alignment area by moving the second light emitting element to at least one of the gravitational influence zone and the electric field influence zone of the alignment area using a flow supply apparatus.

4. The method of claim 3, wherein the using the flow supply apparatus comprises:
generating the flow using a flow medium with a flow generator;
injecting the flow from a flow supply line into the fluid layer with a flow injector; and
controlling the flow of the flow supply line based on a measurement of the flow with a flow controller.

5. The method of claim 4, wherein the generating the flow using the flow medium comprises:
outputting the flow medium including at least one of liquid and gas to the flow supply line at a predetermined speed.

6. The method of claim 4, wherein the injecting the flow from the flow supply line into the fluid layer comprises:
injecting the flow from a plurality of flow injectors provided at intervals in the non-alignment area of the base substrate.

7. The method of claim 4, wherein the controlling the flow of the flow supply line based on the measurement of the flow comprises:
reducing the flow based on the flow of the flow supply line being faster than a predetermined reference flow; and
increasing the flow based on the flow of the flow supply line being slower than the predetermined reference flow.

8. The method of claim 4, wherein the injecting the flow from the flow supply line into the fluid layer comprises:
injecting the flow medium in one direction through an injection port, and
wherein the moving the second light emitting element provided to the non-alignment area of the base substrate to the alignment area by applying the flow to the fluid layer comprises:
moving the second light emitting element to at least one alignment area adjacent to the non-alignment area by applying the flow in a direction within the fluid layer through the injection port.

9. The method of claim 4, wherein the injecting the flow from the flow supply line into the fluid layer comprises:
injecting the flow through two injection ports injecting the flow medium in a first direction and a second direction different from the first direction, and
wherein the moving the second light emitting element provided to the non-alignment area of the base substrate to the alignment area by applying the flow to the fluid layer comprises:
moving the second light emitting element to at least one alignment area adjacent to the non-alignment area by applying the flow in the first direction and the second direction through the two injection ports.

10. The method of claim 4, wherein the injecting the flow from the flow supply line into the fluid layer comprises:
generating a vortex in at least one of a clockwise direction and a counterclockwise direction in the fluid layer by injecting the flow medium, and
wherein the moving the second light emitting element provided to the non-alignment area of the base substrate to the alignment area by applying the flow to the fluid layer comprises:
moving the second light emitting element to at least one alignment area adjacent to the non-alignment area based on the vortex.

11. A display device, comprising:
at least one electrode; and
a plurality of light emitting elements aligned with the at least one electrode,
wherein, in a process of aligning the plurality of light emitting elements to the at least one electrode, the plurality of light emitting elements are supplied to a fluid layer, and provided to a base substrate comprising an alignment area and a non-alignment area,
wherein a first light emitting element provided to the alignment area is aligned with the at least one electrode using an electric field, and
wherein a second light emitting element provided to the non-alignment area moves to the alignment area based on a flow applied to the fluid layer.

12. The display device of claim 11, wherein, in the process of aligning the plurality of light emitting elements to the at least one electrode:
at least one of the plurality of light emitting elements is lowered in a vertical direction by gravityin a gravitational influence zone of the fluid layer, and is rotated by at least one of electrophoresis and dielectrophoresis in an electric field influence zone of the fluid layer.

13. The display device of claim 12, wherein the second light emitting element provided to the non-alignment area of the plurality of light emitting element is aligned with the at least one electrode of the alignment area by being moved to at least one of the gravitational influence zone and the electric field influence zone of the alignment area by a flow supply apparatus.

14. An alignment structure of a light emitting element, comprising:
a base substrate comprising an alignment area and a non-alignment area;
at least one electrode provided on the base substrate; and
a flow supply apparatus provided on the base substrate,
wherein, based on a first light emitting element, among a plurality of light emitting elements, being provided through a fluid layer to at least one electrode of the alignment area, an electric field is configured such that the first light emitting element aligns with the at least one electrode, and
wherein the flow supply apparatus is configured to move a second light emitting element, among the plurality of light emitting elements, provided in the non-alignment area to the alignment area by applying a flow to the fluid layer.

15. The alignment structure of claim 14, wherein, based one of the plurality of the light emitting elements being lowered in a vertical direction by gravityin a gravitational influence zone of the fluid layer, the electric field is configured such that the one of the plurality of light emitting elements:
rotates by at least one of electrophoresis and dielectrophoresis in an electric field influence zone of the fluid layer, and
aligns with the at least one electrode.
